# EUROPEAN PATENT SPECIFICATION

(11) **EP 0 476 187 B1**
(45) Date of publication and mention of the grant of the patent: **20.05.1998**
(21) Application number: 90202490.0
(22) Date of filing: 20.09.1990
(51) Int. Cl.: G03F 7/038, G03F 7/20, C08F 20/34, C08F 20/36

(54) **A highly photosensitive imaging element based on a photosensitive resin**
Auf einem photoempfindlichen Harz basierendes lichtempfindliches bilderzeugendes Element
Elément formateur d'images à photosensibilité élevée, basé sur une résine photosensible

(43) Date of publication of application: 25.03.1992
(73) Proprietor: AGFA-GEVAERT N.V., 2640 Mortsel (BE)
(72) Inventor: Delzenne, Gerard Albert, B-2232 s'Gravenwezel (BE); De Schrijver, Frans Carl, B-3202 Linden (BE); Van den Broeck, Hilde, B-2400 Mol (BE); Voortmans, Gilbert Johannes, B-2340 Beerse (BE); Jackers, Carina Maria, B-3740 Bilzen (BE); Vangilbergen, An Cordula, B-3210 Lubbeek (BE)

(56) References cited:
- US-A- 3 859 091
- US-A- 4 444 868

## Description

### 1. Field of the invention.

The present invention relates to a photosensitive resin of high sensitivity and to a method for producing a highly photosensitive imaging element. The present invention also provides a method for producing an image with said photosensitive imaging element.

### 2. Background of the invention.

Photosensitive resins (photo-insolubilizable high molecular weight compounds) have found acceptance for actual use as materials for printing plates, as photoresists i.a. for photoetching and phototrimming, and as photosensitive vehicles i.a. for paints and printing inks. Several types of photo-cross-linkable groups have been introduced in a variety of polymers to obtain a photosensitive resin. Among these photo-cross-linkable groups are the cinnamoyl group, acryloyl group, azide group etc.. However these groups show a rather low sensitivity typically of the order of 10⁵ mJ/m². All sensitivity values given in this text, unless otherwise stated, correspond to the minimum light energy required to start the gelation of the photosensitive resin.

Attempts have been made to increase the sensitivity of these resins. For example NL-P-7012180 describes the application of an overall light-exposure of an azide based resin before the imagewise exposure of the resin. This method has however the disadvantage that the stability of the overall exposed resin drastically drops so that the time between the overall exposure and the imagewise exposure must be kept small.

An attempt to increase the photosensitivity of a cinnamoyl based resin is described in EP-A-240276. The application describes the introduction of the cinnamoyl group in a liquid crystalline phase. In this case the sensitivity can be increased about 100 times relative to a resin containing cinnamoyl groups in an amorphous phase. This method has however the disadvantage that relative large amounts of cinnamoyl groups have to be introduced in the resin thus increasing its cost.

EP-A-261981 and EP-A-313220 describe the use of a hydrolyzed polyvinylacetate polymer wherein part of the free hydroxyl groups are saponified with styrylpyridinium or styrylquinolinium groups as a photosensitive resin. Even at rather low content of styryl groups in the resin, a high sensitivity is obtained. However after crosslinking the resin still shows a high tendency for swelling with water so that a low resolving power is obtained.

US-P-4444868 discloses the use of polymers with substituted nitrogen containing heterocyclic residues e.g. styrylpyridinium or styrylquinolinium containing methacrylate polymers. This type of resin shows a sensitivity of about 10⁴ mJ/m² and shows good resolving power. It is mentioned that the non-quaternized derivatives of the styryl group containing methacrylate polymers show a much lower photosensitivity.

US-P-3,859,091 discloses a process for forming printing plates or pattern plates including a layer of photocured liquid photocurable polymer on a support comprising first directly exposing said photocurable polymer layer to actinic radiation for a brief time and then further exposing the layer to actinic radiation trough an imagr bearing transparency until the layer is substantially completely cured in the exposed image areas. The sensitivity of said material is not disclosed.

However a photosensitivity of less than 10⁴ mJ/m² is desirable for applications using laser light exposure for example in the production of printing plates in a computer to plate configuration.

It is an object of the present invention to provide a photosensitive resin of high sensitivity.

It is a further object of the present invention to provide a method for obtaining an imaging element, based on a photosensitive resin, showing a high sensitivity, a high resolving power and a high stability.

### 3. Summary of the invention.

The present invention provides a photosensitive imaging element as defined in claim 1.

According to the present invention a method is provided for obtaining a highly photosensitive imaging element which comprises the steps set out in claim 4.

According to the present invention there is also provided a method for obtaining an image comprising the steps set out in claim 7.

The present invention also provides new (co)polymers as set out in claim 12.

### 4. Detailed description of the invention.

Monomers having the styryl type nitrogen-containing heterocyclic ring correspond to the general formula: 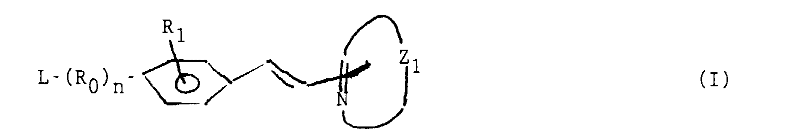 wherein L represents a group which can be polymerized by the radical polymerization method, R₀ corresponds to the formula :

- (CH₂)ₛ - (O)ₜ -

wherein s is an integer of at least 6 and t can be 0 or 1, R₁ represents hydrogen, an alkyl or alkoxy group, Z₁ represents the atoms necessary to complete an aromatic heterocyclic ring including a substituted heterocyclic ring and heterocyclic ring with fused aromatic or heterocyclic rings and n is 1.

The above styryl type nitrogen-containing heterocyclic ring monomers when contained in a homopolymer or copolymer can be quaternized to units of the general formula: 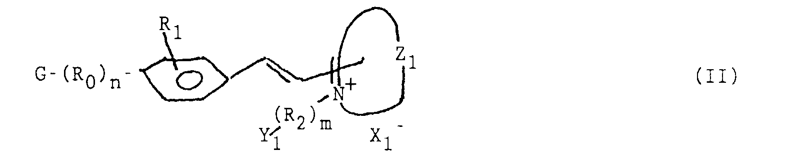 wherein R₀, R₁ and Z₁ have the same meaning as in general formula I, G represents a linking group to the polymer backbone for example an amide or an ester group, R₂ represents a divalent organic residue e.g. alkylene, alkoxyalkylene etc., X₁ represents an anion e.g. a halide ion, a sulphate ion e.g. methyl sulphate etc., Y₁ represents hydrogen, a hydroxyl group, an amide or an ester group, n may be 0 or 1, m may be 0 if Y₁ represents hydrogen and otherwise equals 1.

Examples of monomers of the general formula (I) are:

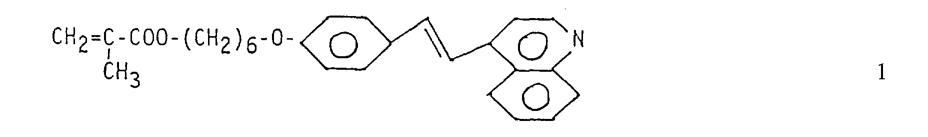

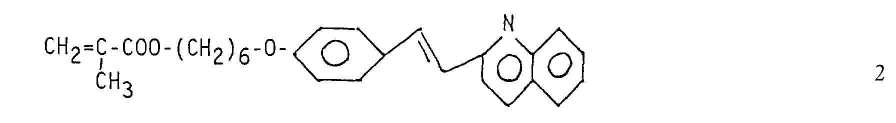

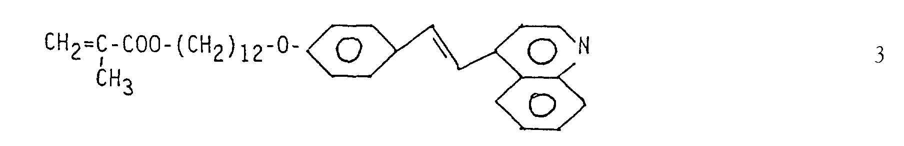

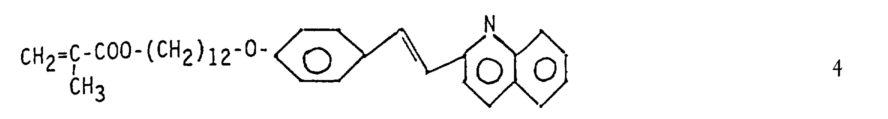

Examples of units corresponding to the general formula (II) are:

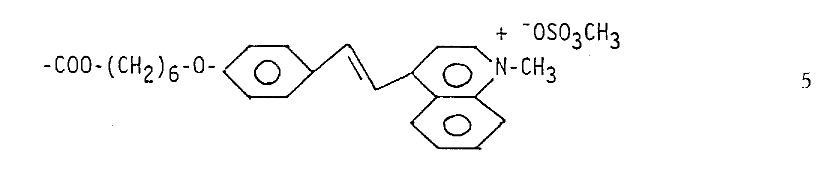

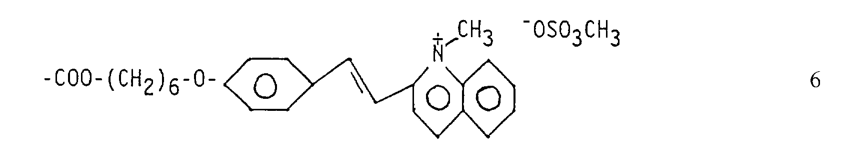

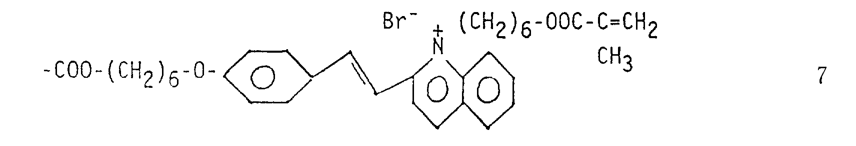

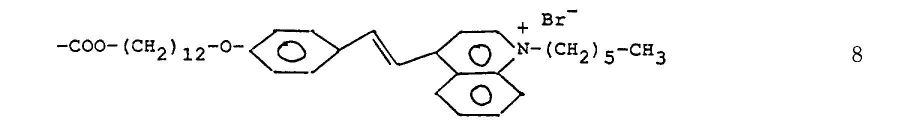

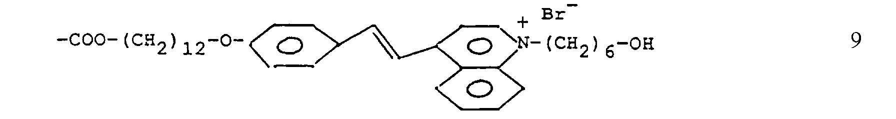

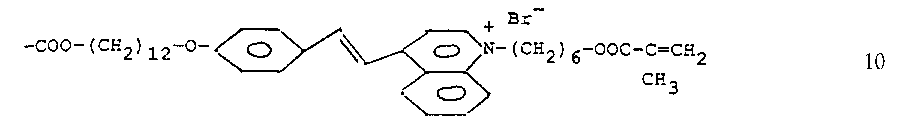

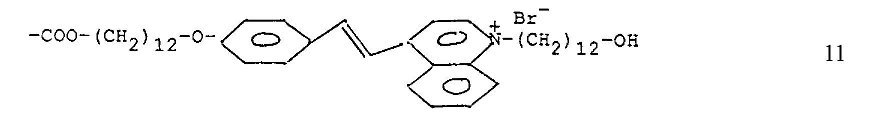

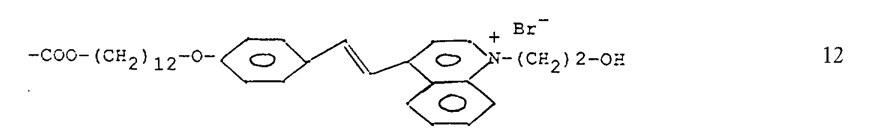

The above mentioned monomers of the styryl type nitrogen-containing heterocyclic ring, are new. The quaternized styryl type nitrogen containing heterocyclic ring corresponding to general formula (II) are new.

The novel styryl type nitrogen-containing heterocyclic ring residues as contained in their quaternized form in a homopolymer or copolymer and of which residues 7 to 12 are representatives correspond to the general formula: 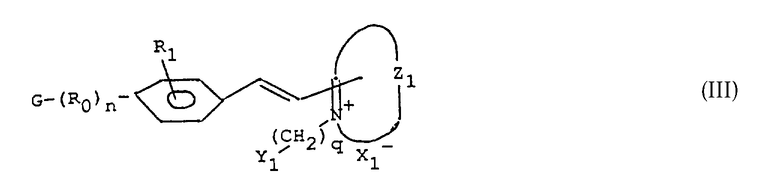 wherein R₁, R₀, Z₁ and X₁ have the same meaning as in general formula I and G and Y₁ have the same meaning as in formula II, n is 1, q is an integer of at least 6 if Y₁ represents a hydrogen and otherwise an integer of at least 2.

The monomers corresponding to general formula (I) can be synthesized according to known methods. See for example US-P-4444868.

The homopolymer or copolymer can be prepared by known radical polymerization methods. The monomers corresponding to general formula (I) can be copolymerized with several comonomers for example acrylonitrile, acrylic and methacrylic acid, acrylic ester for example alkyl acrylic esters and 2-hydroxyethyl acrylate, methacrylic ester for example alkyl methacrylic esters and 2-hydroxyethyl methacrylate, acrylamide, methacrylamide, alkyl acrylamides, alkyl methacrylamides for example N,N-dimethylmethacrylamide, styrene, methylstyrene, vinylacetate, vinylether, 1,3-butadiene, 2-vinylpyridine, N-vinylpyrrolidone etc.. These vinyl comonomers may be used in various desired combinations of two or more members.

Preferably said homopolymer or copolymer has a weight average molecular weight between 10000 and 500000.

Preferably a copolymer is prepared having a glass-transition temperature between 30°C and 70°C to allow a thermal treatment at a convenient temperature.

The homopolymer or copolymer containing a monomer corresponding to general formula (I) is preferably quaternized with a suitable quaternizing agent for example an acid, e.g. p-toluenesulfonic acid, hydrochloric acid, hydrobromic acid and acetic acid, alkyl and alkylaryl quaternizing agents for example methylbromide, ethylbromide and n-hexylbromide, hydroxyalkyl quaternizing agents for example, 2-hydroxyethylbromide, 2-hydroxyethylchloride, 3-hydroxypropylbromide, 6-hydroxyhexylbromide, 6-hydroxyhexylchloride, 12-hydroxydodecylbromide, 6-bromohexylmethacrylate, 6-chlorohexylmethacrylate, 12-bromododecylmethacrylate, 6-bromohexylacrylate, N-(6-bromohexyl)acrylamide, N-(6-bromohexyl )methacrylamide etc..

If desired said homopolymer or copolymer containing a monomer corresponding to general formula (I) and quaternized with a quaternizing agent containing a hydroxy may be reacted with an organic acid for example acetic acid, benzoic acid, propionic acid methacrylic acid, acrylic acid, or an organic acid chloride for example acetic acid chloride, benzoyl chloride, methacryloyl chloride, acryloyl chloride to introduce an ester in the quaternizing group of the nitrogen-containing heterocyclic ring.

It was surprisingly found that the homopolymer or copolymer quaternized with a quaternizing agent containing a hydroxy group or a quaternizing agent ccntaining at least six carbon atoms in the chain showed a remarkable higher sensitivity than the styryl type resins disclosed in US-P-4444868.

In a preferred embodiment of the invention for the production of a high photosensitive imaging element of the invention, an imaging element is produced by coating on a support a copolymer of 10 to 95 mol% of methylmethacrylate 0 to 40 mol% of n-butylmethacrylate and 1 to 50 mol% of at least one monomer corresponding to general formula (I), the latter monomers being quaternized from 5 to 100% to a unit of general formula (II) or (III). The thus obtained imaging element shows a high sensitivity even at low content of the styryl substituted units. However the sensitivity can be further increased by keeping the imaging element at an elevated temperature of 50°C to 150°C for 5 minutes to 2 hours and/or overall exposing the imaging element to light having (a) wavelength(s) in the range of 300 to 600nm and an energy of less than the energy needed to start gelation of the photosensitive copolymer. An overall exposure to light may be carried out before, after or simultaniously with the mentioned thermal treatment of the imaging element.

The start of gelation can be easily determined by the following procedure. Each of a series of samples of a photosensitive coating on a support is exposed with a different energy dose and subsequently developed to remove the insufficiently cross-linked photosensitive coating. The start of detectable amount of the photosensitive coating remains on the support.

At this point it is interesting to mention that the method of overall exposing to light of the imaging element can equally be applied to imaging elements containing other photosensitive resins based on photo-dimerizable groups e.g. resins containing cinnamoyl groups to increase the sensitivity of these resins while keeping the excellent storage properties. However the increase of the sensitivity with these resins appears to be less than the gain in sensitivity found with the styryl type nitrogen containing heterocyclic ring resins.

The present invention also provides different modes for the production of an image. In a preferred mode the imaging element of the present invention is imagewise exposed and the insufficiently cross-linked photosensitive coating is removed. The overall exposure and/or thermal treatment can be effected directly before said image-wise exposure or it can have been effected long before e.g. at the stage of manufacturing the imaging elements.

Removal of the insufficiently cross-linked photosensitive coating is preferably done using a solvent. Adequate solvents are solvents which are good solvents for the non-cross-linked photosensitive polymer. Such solvents can be easily determined by a person skilled in the art using a simple experimental test. Suitable solvents for the photosensitive composition of the present invention are e.g. chloroform, dichloromethane, dichloroethane toluene, benzene etc..

According to the invention imagewise exposure may be carried out with any light-source emitting light in the wavelength range of 200nm to 600nm, preferably from 300nm to 500nm. Suitable light-sources are carbon arcs, mercury vapour lamps, fluorescent lamps, argon glow lamps, photographic flood lamps, tungsten lamps and even ordinary daylight. Especially preferred light-sources are lasers for example an Argon ion laser or Neodymium Yag laser. Imaging elements comprising a transparant support are preferably imagewise exposed through the back.

Supports that are suitable for use in the present invention are e.g. paper which may be coated at one or both sides with an alpha-olefin polymer e.g. polyethylene, cellulose nitrate film, cellulose acetate film, poly(vinyl acetal) film, polystyrene film, polyester films for example poly(ethylene terephthalate) film, polycarbonate film, poly-alpha-olefins for example polyethylene and polypropylene film, glass or metal supports for example aluminium, zinc.

If the support is made of a transparant film or glass, transparancies can be made starting from the photosensitive resin which may contain dyes or pigments. These transparancies may be used for projection, e.g. with an overhead projector. If the support is made of metal a photoresist can be prepared with a photosensitive composition coating according to the present invention, which resist may be used as etch resist.

In the production of miniaturized integrated electrical components the photosensitive coating can serve to form a shielding pattern or mask, e.g. , on a semiconductor substrate or insulator wherein by techniques for example vapour deposition, oxidation, ion implantation, electrodeless deposition, ion-milling or etching, matter is added or removed to offer the desired electronic properties to non-shielded material.

The photosensitive coating may further be used for the production of micro-images. For that purpose the photosensitive resin is applied to a thin highly opaque black or grey metal coating on a film support, the metal coating being etchable and thus serving as the imaging layer. After imagewise exposure of the photosensitive resin the non-exposed or insufficient exposed portion of the photosensitive resin are removed by a suitable solvent so that the remaining cross-linked resin will serve as a resist in a subsequent etching of the underlying metal layer.

Likewise the photosensitive coating may be used for the production of printed circuits when the photosensitive coating is applied to a supported copper layer. The photosensitive coating can also be applied to metal plates or drums of zinc, steel, copper or an etchable magnesium alloy for the production of relief printing plates.

As is apparent from the above, the photosensitive resin can be used in a variety of applications.

The imaging element is however especially suitable for the production of lithographic or planographic printing plates. For that purpose the photosensitive coating is applied to a support which is sufficiently hydrophylic. Supports that can be used are for example metal supports such zinc and aluminium, paper or a polyester film support or paper support coated with a hydrophylic layer of TiO₂ contained in a layer of polyvinyl alcohol hardened with an alkylorthosilicate as is described in e.g. US-P-3971660. According to the invention the photosensitive coating is overall exposed to light with an energy dose less than the energy dose necessary to induce the start of gelation and/or the photosensitive resin is brought at an elevated temperature e.g. a temperature of 50 to 150°C for 5 minutes to five hours. The thus prepared imaging element is then imagewise exposed and the non-exposed or insufficiently exposed photosensitive coating is removed by a suitable solvent. A negative lithographic printing plate is thus obtained since the exposed areas will be hydrophobic and thus accept a hydrophobic ink while the non-exposed areas will repell the hydrophobic ink.

The invention will now be illustrated by the following examples without limiting it thereto. All parts are by weight unless otherwise specified.

### EXAMPLE 1

2-(2-(4-methacryloyloxy-6-hexyloxyphenyl)ethenyl)-quinoline (compound 2) was prepared in three steps as follows.
(1) A mixture of 30g (0.25mol) of p-hydroxybenzaldehyde and 38g (0.27mol) of 2-methylquinoline was refluxed in 64g (0.63mol) of acetic anhydride. After 20 hours about 30ml acetic acid was removed under reduced pressure. 40ml of concentrated hydrochloric acid was then added dropwise to the cooled residue and the reaction mixture was stirred for 1/2 hour. 72ml of demineralized water was then added to the mixture which was subsequently stirred at 90°C for 2 hours. Cooling this mixture to room temperature resulted in an orange precipitate, which was subsequently suspended in demineralized water and neutralized with diluted ammonia. After stirring for two hours, yellow crystals were separated, washed and recrystallized from n-butanol. These crystals were identified as 2-(2-(4-hydroxy)phenylethenyl)quinoline.
(2) An equimolar amount of 2-(2-(4-hydroxy)phenylethenyl)-quinoline and sodium hydroxide were dissolved in a minimum amount of demineralized water. To this solution an equimolar amount of 6-bromo-1-hexanol dissolved in methanol and a few crystals of potassium iodide were added. The reaction mixture was stirred and refluxed overnight. Cooling the mixture to room temperature yielded a yellow precipitate which was extensively washed and dried. The yellow crystals were identified as 2-(-2-(4-hydroxy-6-hexyloxyphenyl)ethenyl)-quinoline.
(3) 0.05 mol of 2-(-2-(4-hydroxy-6-hexyloxyphenyl)ethenyl)-quinoline and 0.2 mol of triethylamine were dissolved in a minimum amount of dry dichloromethane. Methacryloylchloride (0.2 mol) dissolved in 100 ml of dry dichloromethane was then dropwise added and the mixture was stirred for twelve hours at room temperature. The reaction mixture was then several times washed with water. The dichloromethane fraction was dried and subsequently removed under reduced pressure. The residue was chromatographically purified using aluminium oxide as the solid phase and chloroform as eluent. The resulting 2-(2-(4-methacryloyloxy-6-hexyloxyphenyl)ethenyl)-quinoline was recrystallized from ethanol.

### EXAMPLE 2

4-(2-(4-methacryloyloxy-6-hexyloxyphenyl)ethenyl)-quinoline (compound 1) was prepared using the procedure described in example 1. 4-methylquinoline was used instead of 2-methylquinoline in the first step of the procedure.

### EXAMPLE 3

2-(2-(4-methacryloyloxy-12-dodecyloxyphenyl)ethenyl)-quinoline (compound 4) was prepared using the procedure described in example 1. 12-bromo-1-decanol was used in step 2 of the procedure instead of 6-bromo-1-hexanol

### EXAMPLE 4

4-(2-(4-methacryloyloxy-12-dodecyloxyphenyl)ethenyl)-quinoline (compound 3) was prepared using the procedure described in example 1. 4-methyl-quinoline was used instead of 2-methyl-quinoline in step 1 and 12-bromo-1-decanol was used in step 2 of the procedure instead of 6-bromo-1-hexanol.

### EXAMPLE 5

5.4g of 4-(2-(4-methacryloyloxy-12-dodecyloxyphenyl)ethenyl)-quinoline, 2.9g of methylmethacrylate, 3.6g of n-butylmethacrylate and 81mg of azobisisobutyronitrile (AIBN) were dissolved in 27ml of toluene. The solution was degassed, kept under reduced pressure and heated at 70°C. After 20 hours the solution was cooled and diluted with dichloromethane. The polymer was then precipitated in methanol. The resulting polymer contained 15 mol % of 4-(2-(4-methacryloyloxy-12-dodecyloxyphenyl)ethenyl)-quinoline, 41 mol % of methylmethacrylate and 44 mol % of n-butylmethacrylate. The molecular weights were M_{w}=77400g/mol and Mₙ=34200g/mol.

1g of this polymer was dissolved in 10ml of dichloroethane together with 8g of 6-bromo-hexylmethacrylate. The solution was stirred at 60°C for 60 hours. The resulting quaternized polymer was precipitated in n-hexaan. 20 mol% of the 4-(2-(4-methacryloyloxy-12-dodecyloxyphenyl)ethenyl)-quinoline units contained in the polymer were quaternized with the hexylmethacrylate group.

A solution of 100mg in 10ml of dichloroethane was coated on a polyethylene terephthalate film, which had been provided with a hydrophilic adhesive layer, to a dry thickness of 2µm.

The thus obtained imaging element was given an overall light exposure and/or thermal treatment according to table I and was subsequently imagewise exposed through the back. The overall exposure and imagewise exposure were carried out on a DUPLIPHOT commercially available from Agfa-Gevaert N.V. with an output of 600µJ/cm². The samples were each developed by rinsing the imagewise exposed samples with dichloromethane. The absorption of the quaternized styryl type units was measured at the exposed areas of each of the samples. The lowest energy dose for which there was detected an absorption of the quaternized styryl type units corresponds to the sensitivity values mentioned in table I.

**Table I**

| Overall exposure (*10³mJ/m²) | Thermal treatment | | Sensitivity (*10³mJ/m²) |
|---|---|---|---|
| | time (s) | T(°C) | |
| - | - | - | 4.2 |
| 3.7 | - | - | 0.9 |
| - | 1200 | 80 | 3.7 |
| - | 2700 | 80 | 2.8 |
| 3.7 | 1800 | 80 | 0.4 |
| - | 1800 | 100 | 1.4 |
| - | 2700 | 100 | 0.3 |
| 3.7 | 1800 | 100 | 0.3 |

Table I shows that the sensitivity of the imaging element can be substantially increased when the imaging element is given a thermal treatment and/or an overall light exposure before the imagewise exposure.

### EXAMPLE 6

For the sake of comparison a styryl type polymer as disclosed in US-P-444868 using a procedure disclosed therein was prepared. The thus prepared comparitive polymer contained 89 mol% methylmethacrylate and 11 mol% 4-(2-(4-methacryloyloxy-2-ethyloxy-phenyl)ethenyl)-quinoline of which 41 mol% was quaternized with dimethyl sulfate. The weight average and number average molecular weight were respectively 149200 and 70700.

According to the procedure described in example 5 a copolymer containing 90 mol% methylmethacrylate and 10 mol% 4-(2-(4-methacryloyloxy-12-dodecyloxyphenyl)ethenyl)-quinoline was prepared. A polymer with a weight average and number average molecular weight of respectively 166400 and 83200 was obtained and subsequently quaternized with 6-bromohexanol so that 31 mol% of the quinoline groups were converted.

Two different samples were prepared by coating each of the above prepared polymers on a polyethylene terephthalate film to a dry thickness of 2µm according to the procedure described in example 5. Both samples were imagewise exposed without previous overall exposure or thermal treatment as described in example 5.

The sensitivity of the comparative sample was about 4 times less than the sample of the invention.

### EXAMPLE 7

Two copolymers of 4-(2-(4-methacryloyloxy-12-dodecyloxyphenyl)ethenyl)-quinoline (QM) were prepared by copolymerizing QM with methylmethacrylate (MMA) and n-butylmethacrylate (MBA) using the polymerization procedure of example 5. Composition and molecular weights of the copolymers are shown in table II.

**Table II**

| copolymer | MMA (mol%) | MBA (mol%) | QM (mol%) | Mₙ g/mol | M_{w} g/mol |
|---|---|---|---|---|---|
| 1 | 43 | 45 | 12 | 92400 | 184800 |
| 2 | 90 | 0 | 10 | 83200 | 166400 |

The copolymers shown in table II were quaternized according to the procedure of example 5 and subsequently coated on a polyethylene terephthalate film support to a dry thickness of 2µm. The obtained samples were then imagewise exposed without previous overall exposure or thermal treatment as described in example 5. The resulting compositions of the copolymers and the sensitivity of the corresponding samples are shown in table III.

**Table III**

| copolymer | quaternizing agent | QM converted (mol%) | sensitivity (*10³mJ/m²) |
|---|---|---|---|
| 1 | methylsulfate | 33 | 5.6 |
| 1 | 6-bromohexanol | 41 | 0.7 |
| 1 | 6-bromohexylmethacrylate | 40 | 0.9 |
| 2 | 6-bromohexanol | 31 | 0.5 |

Table III shows the important influence of the quaternizing agent on the sensitivety of the resin. The sensitivity can be increased upto 10 times when 6-bromohexanol is used as the quaternizing agent instead of methylsulfate.

### EXAMPLE 8

A copolymer of 4-(2-(4-methacryloyloxy-12-dodecyloxyphenyl)ethenyl)quinoline was prepared by copolymerization with methylmethacrylate and n-butylmethacrylate using the polymerization procedure of example 5. A copolymer containing 15 mol% of the quinoline derivative, 41 mol% of methylmethacrylate and 44mol% of n-butylmethacrylate and having a weight average and number average molecular weight of 77400 and 34200 respectively was thus obtained. 25% of the quinoline groups of the copolymer were quaternized with hexylbromide according to the procedure of example 5 and subsequently coated on a polyethylene terephthalate film support to a dry thickness of 2µm. The obtained sample was then imagewise exposed without an overall exposure or thermal treatment as described in example 5. The sensitivity was 3.6 10³mJ/m².

### EXAMPLE 9

A copolymer of 2-(2-(4-methacryloyloxy-6-hexyloxyphenyl)ethenyl)quinoline was prepared by copolymerization with methylmethacrylate and n-butylmethacrylate using the polymerization procedure of example 5. A copolymer containing 19 mol% of the quinoline derivative, 38 mol% of methylmethacrylate and 43 mol% of n-butylmethacrylate and having a weight average and number average molecular weight of 77800 and 36100 respectively was thus obtained. 14% of the quinoline groups of the copolymer were quaternized with 6-bromohexylmethacrylate according to the procedure of example 5 and subsequently coated on a polyethylene terephthalate film support to a dry thickness of 2µm. The obtained sample was then imagewise exposed as described in example 5. The sensitivity was 5.6 10³mJ/m².

## Claims

1. A photosensitive imaging element, comprising on a support a coating of a photosensitive composition comprising a homopolymer or copolymer of a monomer having a styryl type nitrogen-containing heterocyclic ring wherein the corresponding monomer units have been quaternized from 0 to 100% and wherein said monomer of the styryl type nitrogen-containing heterocyclic ring corresponds to the general formula: 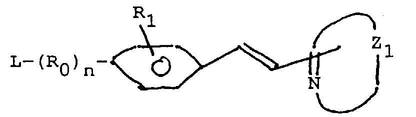 wherein L represents a group which can be polymerized by the radical polymerization method, R₀ corresponds to the formula:
-(CH₂)ₛ-(O)ₜ-
wherein s is an integer of at least 6 and t can be 0 or 1, R₁ represents hydrogen, an alkyl or alkoxy group, Z₁ represents the atoms necessary to complete an aromatic heterocyclic ring including a substituted heterocyclic ring and heterocyclic ring with fused aromatic or heterocyclic rings and n is 1, characterized in that said imaging element has been overall exposed using an energy dose smaller than the energy dose required for inducing gelation of the photosensitive composition and/or has been given a thermal treatment.

2. A photosensitive imaging element according to claim 1 wherein said homopolymer or copolymer contains units with a residue of general formula: 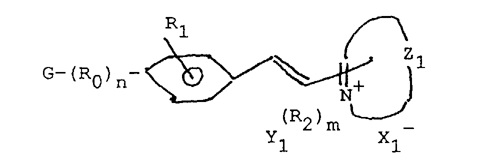 wherein R₀ corresponds to the formula:
-(CH₂)ₛ-(O)ₜ-
wherein s is an integer of at least 6 and t can be 0 or 1, R₁ represents hydrogen, an alkyl or alkoxy group, Z₁ represents the atoms necessary to complete an aromatic heterocyclic ring including a substituted heterocyclic ring and heterocyclic ring with fused aromatic or heterocyclic rings, G represents a linking group to the polymer backbone, R₂ represents a divalent organic residue, X₁ represents an anion, Y₁ represents hydrogen, a hydroxyl group, an amide or an ester group, n may be 0 or 1, m may be 0 if Y₁ represents hydrogen and otherwise is 1.

3. A photosensitive imaging element according to claim 2 wherein R₂ is an alkylene chain of at least 6 carbon atoms if Y₁ represents hydrogen and otherwise an alkylene chain of at least 2 carbon atoms.

4. A method for obtaining a photosensitive imaging element which comprises the steps of (i) coating on a support a photosensitive composition comprising a homopolymer or copolymer of a monomer having a styryl type nitrogen-containing heterocyclic ring wherein the monomer of the styryl type nitrogen-containing heterocyclic ring is as defined in claim 1 and wherein the corresponding monomer units have been quaternized from 0 to 100%, and (ii) overall exposing said coating to an energy dose smaller than the energy dose required for inducing the start of gelation of the photosensitive composition and/or giving a thermal treatment to said coating.

5. A method according to claim 4 wherein said homopolymer or copolymer contains units with a residue as defined in claim 2.

6. A method according to any of claim 4 or 5 wherein said homopolymer or copolymer contains units with a residue as defined in claim 3.

7. A method for obtaining an image comprising the steps of (i) overall exposing a photosensitive imaging element comprising a support coated with a photosensitive composition, comprising a homopolymer or copolymer of a monomer of the styryl type nitrogen-containing heterocyclic ring wherein the corresponding monomer units have been quaternized from 0 to 100% and wherein said monomer of the styryl type nitrogen-containing heterocyclic ring corresponds to the general formula: 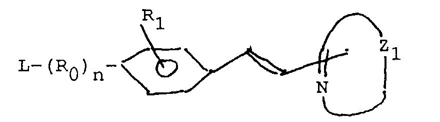 wherein L represents a group which can be polymerized by the radical polymerization method, R₀ corresponds to the formula:
-(CH₂)ₛ-(O)ₜ-
wherein s is an integer of at least 6 and t can be 0 or 1, R₁ represents hydrogen, an alkyl or alkoxy group, Z₁ represents the atoms necessary to complete an aromatic heterocyclic ring including a substituted heterocyclic ring and heterocyclic ring with fused aromatic or heterocyclic rings and n is 1, to an energy dose smaller than the energy dose required for inducing gelation of the photosensitive composition and/or giving a thermal treatment to said imaging element, (ii) imagewise exposing the thus obtained imaging element (iii) developing said imagewise exposed imaging element by removing the insufficiently cross-linked photosensitive coating.

8. A method for obtaining an image according to claim 7 wherein said insufficiently cross-linked photosensitive coating is removed by rinsing with an organic solvent.

9. A method for obtaining an image according to claim 8 wherein said solvent is dichloromethane, dichloroethane, toluene, benzene or a mixtures thereof.

10. A method for obtaining an image according to any of claims 7 to 9 wherein said homopolymer or copolymer contains units with a residue as defined in claim 2.

11. A method for obtaining an image according to any of claims 7 to 9 wherein said homopolymer or copolymer contains units with a residue as defined in claim 5.

12. A homopolymer or copolymer comprising units derived from a monomer corresponding to the general formula: 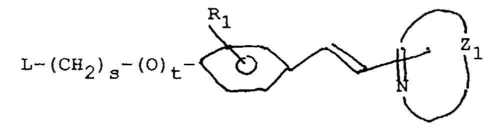 wherein L represents a group which can be polymerized by the radical polymerization method, R₁ represents hydrogen, an alkyl or alkoxy group, Z₁ represents the atoms necessary to complete an aromatic heterocyclic ring including a substituted heterocyclic ring and a heterocyclic ring with fused aromatic or heterocyclic rings, s is an integer of at least 6 and t may be 0 or 1.

13. A homopolymer or copolymer comprising units of the following general formula: 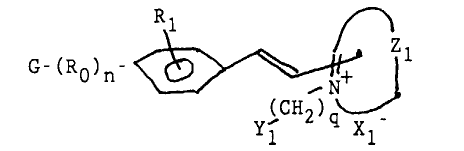 wherein G represents a linking group to the polymer backbone, R₀ corresponds to the formula - (CH₂)ₛ - (0)ₜ -werein s is an integer of at least 6 and t can be 0 or 1, R₁ represents hydrogen, an alkyl or alkoxy group, Z₁ represents the atoms necessary to complete an aromatic heterocyclic ring including a substituted heterocyclic ring and a heterocyclic ring with fused aromatic or heterocyclic rings, X₁ represents an anion, Y₁ represents hydrogen, a hydroxyl group, an amide or an ester group, n is 1 and q is an integer of at least 6 if Y₁ represents a hydrogen and otherwise equals at least 2.

## Patentansprüche

1. Ein lichtempfindliches Bilderzeugungselement, das auf einem Träger eine Schicht mit einer lichtempfindlichen Zusammensetzung enthält, die ein Homopolymeres oder Copolymeres eines Monomeren mit einem stickstoffhaltigen heterocyclischen Ring des Styryltyps enthält, wobei die entsprechenden Monomereinheiten zu 0 bis 100% quaternisiert worden sind und das Monomere mit dem stickstoffhaltigen heterocyclischen Ring des Styryltyps der allgemeinen Formel : 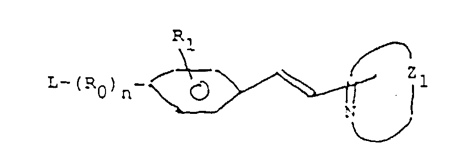 entspricht, in der L eine Gruppe, die durch das Radikalpolymerisationsverfahren polymerisiert werden kann, bedeutet, R₀ der Formel -(CH₂)ₛ-(O)ₜ- entspricht, in der s eine ganze Zahl von wenigstens 6 ist und t 0 oder 1 sein kann, R₁ Wasserstoff, eine Alkylgruppe oder eine Alkoxygruppe bedeutet, z₁ die zum Vervollständigen eines aromatischen heterocyclischen Ringes, einschließlich eines substituierten heterocyclischen Ringes und eines heterocyclischen Ringes mit anellierten aromatischen oder heterocyclischen Ringen, benötigten Atome bedeutet, und n 1 ist, dadurch gekennzeichnet, daß das Bilderzeugungselement mit einer niedrigeren Energieleistung als die zum Auslösen der Gelierung der lichtempfindlichen Zusammensetzung benötigte Energiedosis einer Gesamtbelichtung und/oder einer Wärmeverarbeitung unterzogen wird.

2. Lichtempfindliches Bilderzeugungselement nach Anspruch 1, dadurch gekennzeichnet, daß das Homopolymere oder Copolymere Einheiten mit einem Rückstand entsprechend der allgemeinen Formel : 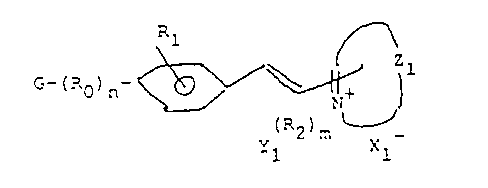 enthält, in der R₀ der Formel -(CH₂)ₛ-(O)ₜ- entspricht, in der s eine ganze Zahl von wenigstens 6 ist und t 0 oder 1 sein kann, R₁ Wasserstoff, eine Alkylgruppe oder eine Alkoxygruppe bedeutet, Z₁ die zum Vervollständigen eines aromatischen heterocyclischen Ringes, einschließlich eines substituierten heterocyclischen Ringes und eines heterocyclischen Ringes mit anellierten aromatischen oder heterocyclischen Ringen, benötigten Atome bedeutet, G eine Verbindungsgruppe mit einer polymeren Hauptkette bedeutet, R₂ einen zweiwertigen organischen Rückstand bedeutet, X₁ ein Anion bedeutet, Y₁ Wasserstoff, eine Hydroxylgruppe, eine Amid- oder eine Estergruppe bedeutet, n 0 oder 1 bedeutet, und m 0 bedeutet, falls Y₁ Wasserstoff bedeutet, und sonst 1.

3. Lichtempfindliches Bilderzeugungselement nach Anspruch 2, dadurch gekennzeichnet, daß R₂ eine Alkylenkette von wenigstens 6 Kohlenstoffatomen ist, falls Y₁ Wasserstoff bedeutet, und sonst eine Alkylenkette von wenigstens 2 Kohlenstoffatomen ist.

4. Ein Verfahren zum Erhalt eines lichtempfindlichen Bilderzeugungselements, das die folgenden Stufen umfaßt : (i) den Auftrag, auf einen Träger, einer lichtempfindlichen Zusammensetzung, die ein Homopolymeres oder Copolymeres eines Monomeren mit einem stickstoffhaltigen heterocyclischen Ring des Styryltyps enthält, wobei das Monomere mit dem stickstoffhaltigen heterocyclischen Ring des Styryltyps in Anspruch 1 definiert ist und die entsprechenden Monomereinheiten zu 0 bis 100% quaternisiert worden sind, und (ii) die Gesamtbelichtung der Schicht mit einer Energiedosis, die kleiner ist als die zum Auslösen der Gelierung der lichtempfindlichen Zusammensetzung erforderliche Energiedosis, und/oder eine Wärmeverarbeitung dieser Schicht.

5. Verfahren nach Anspruch 4, dadurch gekennzeichnet, daß das Homopolymere oder Copolymere Einheiten mit einem wie in Anspruch 2 definierten Rückstand enthält.

6. Verfahren nach Anspruch 4 oder 5, dadurch gekennzeichnet, daß das Homopolymere oder Copolymere Einheiten mit einem wie in Anspruch 3 definierten Rückstand enthält.

7. Ein Bilderzeugungsverfahren, das die folgenden Stufen umfaßt : (i) die Gesamtbelichtung eines lichtempfindlichen Bilderzeugungselements, auf dessen Träger eine lichtempfindliche Zusammensetzung vergossen ist, die ein Homopolymeres oder Copolymeres eines Monomeren mit einem stickstoffhaltigen heterocyclischen Ring des Styryltyps enthält, wobei die entsprechenden Monomereinheiten zu 0 bis 100% quaternisiert worden sind und das Monomere mit dem stickstoffhaltigen heterocyclischen Ring des Styryltyps der allgemeinen Formel : 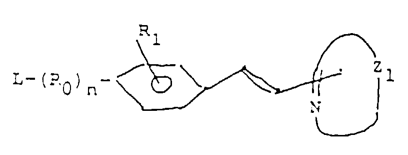 entspricht, in der L eine Gruppe bedeutet, die durch das Radikalpolymerisationsverfahren polymerisiert werden kann, R₀ der Formel -(CH₂)ₛ-(O)ₜ- entspricht, in der s eine ganze Zahl von wenigstens 6 ist und t 0 oder 1 sein kann, R₁ Wasserstoff, eine Alkylgruppe oder eine Alkoxygruppe bedeutet, Z₁ die zum Vervollständigen eines aromatischen heterocyclischen Ringes, einschließlich eines substituierten heterocyclischen Ringes und eines heterocyclischen Ringes mit anellierten aromatischen oder heterocyclischen Ringen, benötigten Atome bedeutet, und n 1 ist, mit einer Energiedosis, die kleiner ist als die zum Auslösen der Gelierung der lichtempfindlichen Zusammensetzung erforderliche Energiedosis, und/oder eine Wärmeverarbeitung des Bilderzeugungselements, (ii) die bildmäßige Belichtung des so erhaltenen Bilderzeugungselements und (iii) die Entwicklung des bildmäßig belichteten Bilderzeugungselements, wobei die in unausreichendem Maße vernetzte lichtempfindliche Schicht entfernt wird.

8. Bilderzeugungsverfahren nach Anspruch 7, dadurch gekennzeichnet, daß die in unausreichendem Maße vernetzte lichtempfindliche Schicht durch Spülen mit einem organischen Lösungsmittel entfernt wird.

9. Bilderzeugungsverfahren nach Anspruch 8, dadurch gekennzeichnet, daß das Lösungsmittel Dichlormethan Dichlorethan, Toluol, Benzol oder eine Mischung derselben ist.

10. Bilderzeugungsverfahren nach irgendeinem der Ansprüche 7 bis 9, dadurch gekennzeichnet, daß das Homopolymere oder Copolymere Einheiten mit einem wie in Anspruch 2 definierten Rückstand enthält.

11. Bilderzeugungsverfahren nach irgendeinem der Ansprüche 7 bis 9, dadurch gekennzeichnet, daß das Homopolymere oder Copolymere Einheiten mit einem wie in Anspruch 5 definierten Rückstand enthält.

12. Ein Homopolymeres oder Copolymeres mit Einheiten, die von einem Monomeren gemäß der allgemeinen Formel : 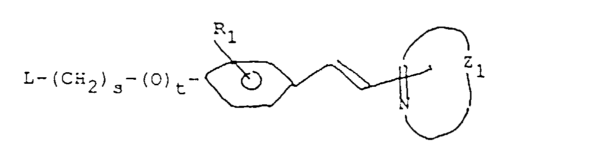 abgeleitet sind, in der L eine Gruppe bedeutet, die durch das Radikalpolymerisationsverfahren polymerisiert werden kann, R₁ Wasserstoff, eine Alkylgruppe oder eine Alkoxygruppe bedeutet, Z₁ die zum Vervollständigen eines aromatischen heterocyclischen Ringes, einschließlich eines substituierten heterocyclischen Ringes und eines heterocyclischen Ringes mit anellierten aromatischen oder heterocyclischen Ringen, benötigten Atome bedeutet, s eine ganze Zahl von wenigstens 6 ist und n 0 oder 1 ist.

13. Ein Homopolymeres oder Copolymeres mit Einheiten, die der allgemeinen Formel : 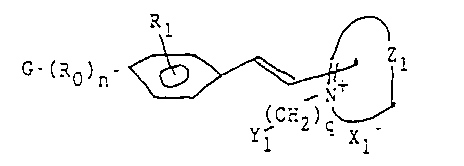 entsprechen, in der G eine Verbindungsgruppe mit der polymeren Hauptkette bedeutet, R₀ der Formel -(CH₂)ₛ-(O)ₜ- entspricht, in der s eine ganze Zahl von wenigstens 6 ist und t 0 oder 1 sein kann, R₁ Wasserstoff, eine Alkylgruppe oder eine Alkoxygruppe bedeutet, Z₁ die zum Vervollständigen eines aromatischen heterocyclischen Ringes, einschließlich eines substituierten heterocyclischen Ringes und eines heterocyclischen Ringes mit anellierten aromatischen oder heterocyclischen Ringen, benötigten Atome bedeutet, X₁ ein Anion bedeutet, Y₁ Wasserstoff, eine Hydroxylgruppe, eine Amid- oder eine Estergruppe bedeutet, n 1 bedeutet, und q eine ganze Zahl von wenigstens 6 ist, falls Y₁ Wasserstoff bedeutet, und sonst wenigstens 2.

## Revendications

1. Un élément formateur d'image photosensible, comprenant sur un support une couche d'une composition photosensible renfermant un homopolymère ou copolymère d'un monomère avec un noyau hétérocyclique de type styryle contenant de l'azote, dans lequel les unités monomères correspondantes ont été quaternisées de 0 à 100 % et dans lequel le monomère du noyau hétérocyclique de type styryle contenant de l'azote correspond à la formule générale: 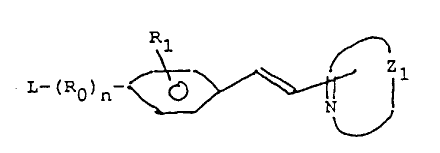 dans laquelle L représente un groupe qui peut être polymérisé par la méthode de la polymérisation radicalaire, R₀ correspond à la formule:
-(CH₂)ₛ - (O)ₜ -
dans laquelle s est un nombre entier d'au moins 6 et t peut être 0 ou 1, R₁ représente un atome d'hydrogène, un groupe alkyle ou alkoxy, Z₁ représente les atomes nécessaires pour compléter un noyau hétérocyclique aromatique, y compris un noyau hétérocyclique substitué et un noyau hétérocyclique avec des noyaux hétérocycliques ou aromatiques condensés, et n est 1, caractérisé en ce que l'élément formateur d'image a été intégralement exposé en utilisant une dose d'énergie inférieure à la dose d'énergie requise pour induire la gélification de la composition photosensible et/ou a reçu un traitement thermique.

2. Un élément formateur d'image photosensible selon la revendication 1, caractérisé en ce que l'homopolymère ou copolymère contient des unités avec un résidu de la formule générale: 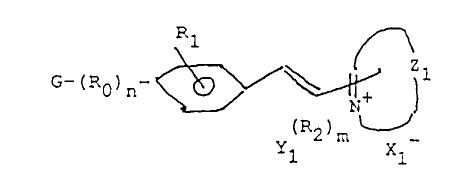 dans laquelle R₀ correspond à la formule:
-(CH₂)ₛ - (O)ₜ -
dans laquelle s est un nombre entier d'au moins 6 et t peut être 0 ou 1, R₁ représente un atome d'hydrogène, un groupe alkyle ou alkoxy, Z₁ représente les atomes nécessaires pour compléter un noyau hétérocyclique aromatique, y compris un noyau hétérocyclique substitué et un noyau hétérocyclique avec des noyaux hétérocycliques ou aromatiques condensés, G représente un groupe de liaison à la chaîne principale polymère, R₂ représente un résidu organique bivalent, X₁ représente un anion, Y₁ représente un atome d'hydrogène, un groupe hydroxyle, un amide ou un groupe ester, n peut être 0 ou 1, m peut être 0 si Y₁ représente un atome d'hydrogène et est 1 dans les autres cas.

3. Un élément formateur d'image photosensible selon la revendication 2, caractérisé en ce que R₂ est une chaîne alkylène d'au moins 6 atomes de carbone si Y₁ représente un atome d'hydrogène et dans les autres cas une chaîne alkylène d'au moins deux atomes de carbone.

4. Un procédé pour obtenir un élément formateur d'image photosensible qui comprend les phases suivantes:
(i) couler sur un support une composition photosensible comprenant un homopolymère ou copolymère d'un monomère avec un noyau hétérocyclique de type styryle contenant de l'azote, dans lequel le monomère du noyau hétérocyclique de type styryle contenant de l'azote est tel que défini à la revendication 1 et dans lequel les unités monomères correspondantes ont été quaternisées de 0 à 100 %, et
(ii) exposer intégralement cette couche à une dose d'énergie inférieure à la dose d'énerqie requise pour induire le démarrage de la gélification de la composition photosensible et/ou donner un traitement thermique à cette couche.

5. Un procédé selon la revendication 4, caractérisé en ce que l'homopolymère ou copolymère contient des unités avec un résidu tel que défini à la revendication 2.

6. Un procédé selon l'une quelconque des revendications 4 ou 5, caractérisé en ce que l'homopolymère ou copolymère contient des unités avec un résidu tel que défini à la revendications 3.

7. Un procédé pour obtenir une image, lequel procédé comprend les phases suivantes:
(i) exposer intégralement un élément formateur d'image photosensible comprenant un support enduit d'une composition photosensible renfermant un homopolymère ou copolymère d'un monomère du noyau hétérocyclique de type styryle contenant de l'azote dans lequel les unités monomères correspondantes ont été quaternisées de 0 à 100 % et dans lequel le monomère du noyau hétérocyclique de type styryle contenant de l'azote correspond à la formule générale: 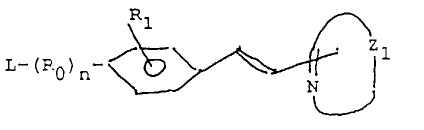 dans laquelle L représente un groupe qui peut être polymérisé par la méthode de polymérisation radicalaire, R₀ correspond à la formule:
-(CH₂)ₛ - (O)ₜ -
dans laquelle s est un nombre entier d'au moins 6 et t peut être 0 ou 1, R₁ représente un atome d'hydrogène, un groupe alkyle ou alkoxy, Z₁ représente les atomes nécessaires pour compléter un noyau hétérocyclique aromatique, y compris un noyau hétérocyclique substitué et un noyau hétérocyclique avec des noyaux hétérocycliques ou aromatiques condensés, et n est 1, à une dose d'énergie inférieure à la dose d'énergie qui est requise pour induire la gélification de la composition photosensible et/ou donner un traitement thermique à l'élément formateur d'image,
(ii) exposer sous forme d'image l'élément formateur d'image ainsi obtenu,
(iii) développer l'élément formateur d'image exposé sous forme d'image en éliminant la couche photosensible insuffisamment réticulée.

8. Un procédé pour obtenir une image selon la revendication 7, caractérisé en ce que la couche photosensible insuffisamment réticulée est éliminée en rinçant avec un solvant organique.

9. Un procédé pour obtenir une image selon la revendication 8, caractérisé en ce que le solvant est du dichlorométhane, du dichloroéthane, du toluène, du benzène ou des mélanges de ceux-ci.

10. Un procédé pour obtenir une image selon l'une quelconque des revendications 7 à 9, caractérisé en ce que l'homopolymère ou copolymère contient des unités avec un résidu tel que défini à la revendication 2.

11. Un procédé pour obtenir une image selon l'une quelconque des revendications 7 à 9, caractérisé en ce que l'homopolymère ou copolymère contient des unités avec un résidu tel que défini à la revendication 5.

12. Un homopolymère ou copolymère comprenant des unités dérivées d'un monomère correspondant à la formule générale: 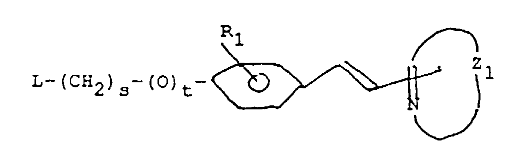 dans laquelle L représente un groupe qui peut être polymérisé par la méthode de la polymérisation radicalaire, R₁ représente un atome d'hydrogène, un groupe alkyle ou alkoxy, Z₁ représente les atomes nécessaires pour compléter un noyau hétérocyclique aromatique, y compris un noyau hétérocyclique substitué et un noyau hétérocyclique avec des noyaux hétérocycliques ou aromatiques condensés, s est un nombre entier d'au moins 6 et t peut être 0 ou 1.

13. Un homopolymère ou copolymère comprenant des unités de la formule générale suivante: 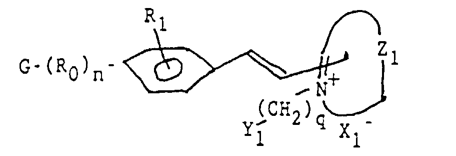 dans laquelle G représent un groupe de liaison à la chaîne principale polymère, R₀ correspond à la formule
-(CH₂)ₛ - (O)ₜ -
dans laquelle s est un nombre entier d'au moins 6 et t peut être 0 ou 1, R₁ représente un atome d'hydrogène, un groupe alkyle ou alkoxy, Z₁ représente les atomes nécessaires pour compléter un noyau hétérocyclique aromatique, y compris un noyau hétérocyclique substitué et un noyau hétérocyclique avec des noyaux hétérocycliques ou aromatiques condensés, X₁ représente un anion, Y₁ représente un atome d'hydrogène, un groupe hydroxyle, un amide ou un groupe ester, n est 1 et q est un nombre entier d'au moins 6 si Y₁ représente un atome d'hydrogène et est autrement égal à au moins 2.
